# EUROPEAN PATENT APPLICATION

(11) **EP 4 495 966 A1**
(43) Date of publication of application: **22.01.2025**
(21) Application number: 22932336.5
(22) Date of filing: 16.12.2022
(51) Int. Cl.: H01H 9/02, H01H 19/02, H01H 19/04, B29C 65/16, H05K 5/00

(54) **ELECTRONIC COMPONENT AND MANUFACTURING METHOD THEREFOR**

(30) Priority: 14.03.2022 JP 2022039396
(71) Applicant: Nidec Copal Electronics Corporation, Shinjuku-ku Tokyo 160-0023 (JP)
(72) Inventor: KOMURO, Tadashi, Sano-shi, Tochigi 327-0104 (JP)
(74) Representative: Meissner Bolte Partnerschaft mbB
(86) International application number: PCT/JP2022/046457
(87) International publication number: WO 2023/176074

(57) **Abstract**

The present invention provides an electronic component that can be colored without the need for a dedicated furnace and a manufacturing method for the electronic component. A casing 11 is formed of a resin material. A cover 12 is formed of the resin material including an oxide layer 12b on a surface, is attached to the casing, and includes an opening 12a. A rotor 14 is arranged inside the casing, and includes an operating portion 14a exposed through the opening of the cover. The cover has a color different from that of the rotor.

## Description

### Technical Field

Embodiments described herein relate generally to an electronic component mounted on, for example, a surface of a printed circuit board and a manufacturing method therefor.

### Background Art

For example, a surface-mounted electronic component such as a dual in-line package (DIP) rotary switch comprises, for example, a casing, a cover attached to the casing, and a rotor that drives a switch mechanism provided within the casing. The casing and the cover are formed of a resin material, and the cover is welded to the casing using, for example, laser beam (cf., for example, JP 2021-18921 A and JP 2021-18922 A).

When the resin material forming the cover is colored by adding, for example, a pigment, the pigment absorbs the laser beam and the cover cannot be welded to the casing. For this reason, in general, the cover is formed of a resin material itself, and the casing is colored by adding a pigment or the like to the resin material. In order to improve the visibility of the cover and the rotor, however, coloring the cover is desired. More specifically, coloring the cover is desired in order to clarify the rotational position of the rotor relative to the cover.

### Summary of Invention

### Technical Problem

Dyes that enable laser beam to be transmitted are commercially available as coloring agents other than pigments. However, since this dye is not a standard material recommended by resin manufacturers, the dye is not covered by the manufacturers' warranty based on UL standards and the like.

In addition, linear polyphenylene sulfide (PPS) resin is used as a resin applicable to the cover and casing. This PPS resin may require heat treatment in order to increase its mechanical strength in small electronic components and the like. When the above-mentioned dye is mixed with the PPS resin and subjected to heat treatment, the dye has a problem of fading due to sublimation. Furthermore, the interior of the furnace is contaminated by gas sublimed from the dye, in the heat treatment. For this reason, when the other components are heat-treated by the contaminated furnace, the other components are also contaminated. Therefore, a dedicated furnace is required to perform the heat treatment.

Embodiments described herein aim to provide an electronic component and a manufacturing method of the same, capable of improving mechanical strength by heat treatment and coloring a component.

### Solution to Problem

According to one embodiment, an electronic component comprises: a casing formed of a resin material; a cover formed of the resin material including an oxide layer on a surface, attached to the casing, and including an opening; and a rotor arranged inside the casing and including an operating portion exposed through the opening of the cover. A color of the cover is different from a color of the rotor.

According to another embodiment, an electronic component manufacturing method comprises: preparing a casing formed of a resin material, a cover formed of the resin material and including an opening, and a rotor formed of the resin material and including an operating portion; forming an oxide layer on a surface of the cover by heat-treating the cover in atmosphere; arranging the rotor in the casing, exposing the operating portion through the opening of the cover, and arranging the cover on the casing; and applying laser beam to surrounding of the cover and welding the cover to the casing. A color of the cover is different from a color of the rotor.

### Brief Description of Drawings

FIG. 1 is a plan view showing an example of an electronic component according to the present embodiment.
FIG. 2 is an exploded perspective view showing several parts of FIG. 1.
FIG. 3 is a cross-sectional view taken along the III-III line in FIG. 1.
FIG. 4 is a flowchart showing a method of manufacturing an electronic component according to the present embodiment.

### Mode for Carrying Out the Invention

Embodiments will be described hereinafter with reference to the accompanying drawings. In the drawings, the same portions are denoted by the same reference numerals.

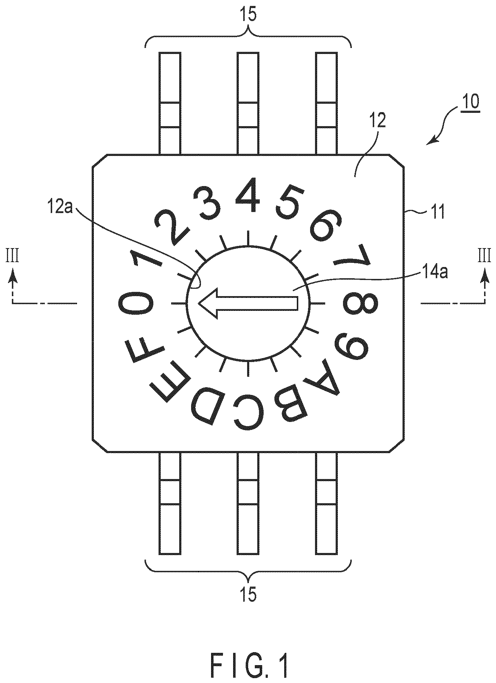

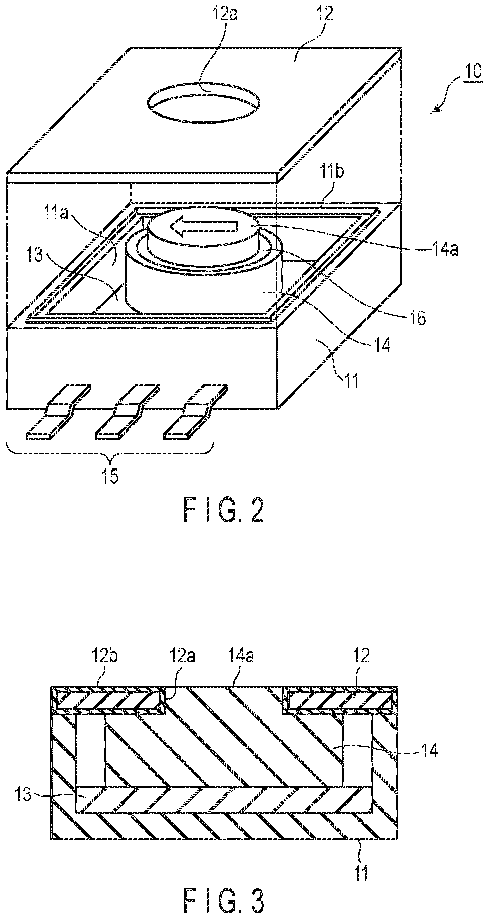

FIG. 1 and FIG. 2 show an example of an electronic component 10 according to the present embodiment. It is shown that the electronic component 10 is a surface-mounted component, and is, for example, a DIP rotary switch. However, the present embodiment is not limited to the switch, but can be applied to other electronic components.

The electronic component 10 comprises, for example, a casing 11 serving as a housing, a cover 12, a switch mechanism 13, a rotor 14, a plurality of terminals 15, and an O-ring 16.

The casing 11 is formed of resin and includes a recess 11a. The switch mechanism 13 and the rotor 14 are arranged within the recess 11a. The plurality of terminals 15 are connected to the switch mechanism 13. The plurality of terminals 15 may be arranged in the casing 11 together with the switch mechanism 13 by insert molding. Alternatively, the casing 11 may be configured to include a base and a side wall provided around the base, such that the side wall may be attached to the base after the switch mechanism 13 and the plurality of terminals 15 are arranged on the base.

A protrusion 11b is continuously provided on the casing 11 located around the recess 11a. This protrusion 11b absorbs the laser beam emitted through the casing 11 and is melted, which will be described later. The melted protrusion 11b fixes the cover 12 to the casing 11. However, the protrusion 11b can also be omitted. In other words, the protrusion 11b can be omitted if it is possible to melt the casing 11 around the recess 11a, sufficiently join the cover 12 to the casing 11, and maintain the airtightness inside the recess 11a.

The cover 12 is formed of, for example, the same resin as the casing 11, and an opening 12a is provided in the center of the cover 12. An operating portion 14a of the rotor 14 is rotatably inserted into the opening 12a. The rotor 14 is coupled to the switch mechanism 13 and is operated to switch the switch mechanism 13.

Since a configuration of the switch mechanism 13 is not the essence of the present embodiment, a specific configuration is not shown. However, the switch mechanism 13 can include a plurality of fixed contacts (not shown) connected to a plurality of terminals 15, a common contact, a movable contact provided on the rotor 14 to electrically connect the fixed contacts and the common contact.

The space between the rotor 14 and the cover 12 is airtight such that entry of moisture and dust into the casing 11 is prevented. More specifically, for example, the O-ring 16 formed of rubber is provided between the periphery of the operating portion 14a and the cover 12, such that entry of moisture and dust through the gap between the opening 12a and the operating portion 14a is prevented.

FIG. 3 shows a cross-section of FIG. 1. Each of the casing 11, the cover 12, and the rotor 14 is formed of, for example, linear polyphenylene sulfide (PPS) resin. PPS resin is originally uncolored, for example, white.

In the present embodiment, the cover 12 has an oxide layer 12b on its surface, and is discolored by the oxide layer 12b. For this reason, a color difference is generated between the operation part 14a of the rotor 14, which has the original color of the resin, and the cover 12 discolored by the oxide layer 12b, and the visibility is improved.

Incidentally, since the cover 12 needs to transmit laser beam, the cover 12 cannot be colored with pigment. However, since the casing 11 does not need to transmit laser beam, the casing 11 may be colored with a pigment that does not sublimate during the heat treatment.

### (Manufacturing Method)

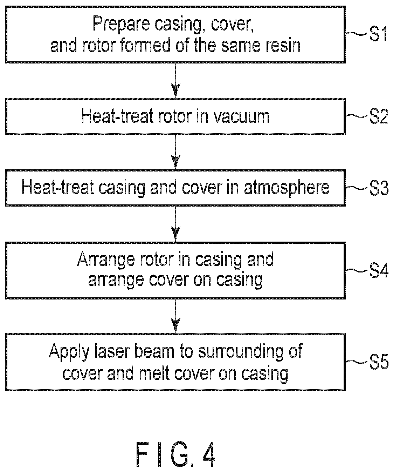

FIG. 4 shows a manufacturing method of the present embodiment. In the present embodiment, appropriate characteristics are imparted to each component by changing the heat treatment method for PPS resin. More specifically, the mechanical strength of the casing 11 and the rotor 14 is increased by the heat treatment. The cover 12 is colored by forming an oxide layer on its surface by the heat treatment, and can further transmit laser beam.

As shown in FIG. 4, first, the casing 11, the cover 12, and the rotor 14 formed of the same PPS resin are prepared (S1). As described above, since the casing 11 does not need to transmit laser beam, the casing 11 may be colored with a pigment. In addition, the switch mechanism 13 and the plurality of terminals 15 may be attached to the casing 11 as long as the heat treatment to be described below can be performed.

Next, the rotor 14 is housed in a furnace (not shown), and the inside of the furnace is evacuated. In this state, for example, the rotor 14 is heat-treated at a temperature of 260°C for 1 hour (S2). The mechanical strength of the rotor 14 is increased by this heat treatment. In addition, since the rotor 14 is heat-treated in a vacuum state, no oxide layer is formed on the surface of the rotor 14.

In contrast, the casing 11 and the cover 12 are heat-treated in the atmosphere, for example, at a temperature of 260°C for one hour (S3). The mechanical strength of the casing 11 and the cover 12 is increased and the oxide layer 12b is formed on the surface of the cover 12, by this heat treatment. The cover 12 is discolored by the oxide layer 12b. Therefore, the cover 12 has a color different from that of the rotor 14.

The thickness of the oxide layer 12b is small as compared to the thickness of the cover 12. Therefore, the transmittance of the laser beam through the cover 12 does not decrease significantly.

Similarly to the surface of the cover 12, an oxide layer is formed on the surface of the casing 11 and discoloring thereby occurs. However, if the casing 11 is colored with a pigment in advance, discoloring of the casing 11, which is caused by the oxide layer, is slight.

The heat treatment of the rotor 14 and the heat treatment of the casing 11 and cover 12 do not need to be performed in this order, and may be performed in a reverse order. Furthermore, these heat treatments may be performed simultaneously.

In addition, when the mechanical strength of the rotor and the casing does not need to be increased, the heat treatments can be omitted.

Next, the rotor 14 is arranged in the recess 11a of the casing 11, and the cover 12 is arranged on the protrusion 11b of the casing 11 (S4). In this state, the operating portion 14a of the rotor 14 is exposed through the opening 12a of the cover 12.

After this, laser beam is applied to the surrounding of the cover 12, and the protrusion 11b of the casing 11 is melted. In other words, the laser beam passes through the cover 12 on which the oxide layer 12b is formed, and is applied to the protrusion 11b of the casing 11. The protrusion 11b absorbs the laser beam and is melted, thereby fixing the cover 12 to the casing 11 (S5).

### (Advantage of Embodiment)

According to the present embodiment, the cover 12 formed of PPS resin has an oxide layer 12b on its surface, and is discolored by the oxide layer 12b. Therefore, the cover 12 has a color different from that of the rotor 14 having the original color of the PPS resin. Therefore, the visibility of the cover 12 and the rotor 14 can be improved.

Furthermore, by heat-treating the cover 12 in the atmosphere, the oxide layer 12b is formed on the surface of the cover 12, and the original color is changed by the oxide layer 12b. Therefore, since the cover 12 can be colored without using dyes or pigments, the cover 12 can easily be manufactured and an increase in manufacturing costs can be suppressed.

In addition, when the casing 11, the cover 12, and the rotor 14 are heat-treated, their mechanical strength can be increased.

Furthermore, no sublimation dye is required to color the cover 12. Therefore, contamination inside the furnace can be prevented. Therefore, since a dedicated furnace is not required, manufacturing is facilitated and the increase in manufacturing costs can be suppressed.

The materials of the casing 11, the cover 12, and the rotor 14 are not limited to PPS resin, but the casing 11, the cover 12, and the rotor 14 can be formed of a material which can form the oxide layer by the heat treatment, for example, one of polyamide (PA) 6T, PA9T, and PA46.

The present invention is not limited to the embodiments described above but the constituent elements of the invention can be modified in various manners without departing from the spirit and scope of the invention. Various aspects of the invention can also be extracted from any appropriate combination of constituent elements disclosed in the embodiments. Some constituent elements may be deleted in all of the constituent elements disclosed in the embodiments. The constituent elements described in different embodiments may be combined arbitrarily.

## Claims

1. An electronic component **characterized by** comprising:
a casing formed of a resin material;
a cover formed of the resin material including an oxide layer on a surface, attached to the casing, and including an opening; and
a rotor arranged inside the casing and including an operating portion exposed through the opening of the cover, wherein
a color of the cover is different from a color of the rotor.

2. The electronic component of claim 1, **characterized in that**
the resin material is linear polyphenylene sulfide (PPS) resin.

3. The electronic component of claim 1, **characterized in that**
the resin material is one of polyamide (PA) 6T, PA9T, and PA46.

4. An electronic component manufacturing method **characterized by** comprising:
preparing a casing formed of a resin material, a cover formed of the resin material and including an opening, and a rotor formed of the resin material and including an operating portion;
forming an oxide layer on a surface of the cover by heat-treating the cover in atmosphere;
arranging the rotor in the casing, exposing the operating portion through the opening of the cover, and arranging the cover on the casing; and
applying laser beam to surrounding of the cover and welding the cover to the casing, wherein
a color of the cover is different from a color of the rotor.

5. The electronic component manufacturing method of claim 4, **characterized in that**
the resin material is linear polyphenylene sulfide (PPS) resin.

6. The electronic component manufacturing method of claim 4, **characterized in that**
the resin material is one of polyamide (PA) 6T, PA9T, and PA46.
